# EUROPÄISCHE PATENTSCHRIFT

(11) **EP 4 400 197 B1**
(45) Veröffentlichungstag und Bekanntmachung des Hinweises auf die Patenterteilung: **25.06.2025**
(21) Anmeldenummer: 24170173.9
(22) Anmeldetag: 01.08.2022
(51) Int. Cl.: B01D 46/00, B01D 46/10, B01D 46/52, H02B 1/56, H05K 7/20

(54) **LUFTEINTRITTS- ODER LUFTAUSTRITTSFILTER FÜR EIN SCHALTSCHRANKGEHÄUSE UND EINE ENTSPRECHENDE SCHALTSCHRANKANORDNUNG**
INLET OR OUTLET AIR FILTER FOR A SWITCHGEAR CABINET HOUSING AND A CORRESPONDING SWITCHGEAR CABINET ASSEMBLY
FILTRE D'ENTRÉE D'AIR OU DE SORTIE D'AIR POUR BOÎTIER D'ARMOIRE ÉLECTRIQUE ET ENSEMBLE D'ARMOIRE ÉLECTRIQUE CORRESPONDANT

(30) Priorität: 03.09.2021 DE 102021122887
(43) Veröffentlichungstag der Anmeldung: 17.07.2024
(62) Teilanmeldung aus: 22753600.0
(73) Patentinhaber: Rittal GmbH & Co. KG, 35745 Herborn (DE)
(72) Erfinder: Weber, Markus, 65620 Waldbrunn (DE)
(74) Vertreter: Angerhausen, Christoph

(56) Entgegenhaltungen:
- JP-A- 2019 013 903
- KR-A- 20100 070 042
- US-A1- 2020 398 205
- US-B1- 6 197 709

## Beschreibung

Die Erfindung geht aus von einer Schaltschrankanordnung mit den Merkmalen des Oberbegriffs des Anspruchs 1. Eine solche Schaltschrankanordnung ist aus der JP 2019013903 A bekannt. Lufteintritts- oder Luftaustrittsfilter für ein Schaltschrankgehäuse, mit einem Filtergehäuse, in dem ein Filtersubstrat mit einem Faltenfilter angeordnet ist, das einen Luftdurchlassquerschnitt des Filtergehäuses vollständig bedeckt sind aus der EP 1 909 548 B1, der US 2020/398205 A1 und der KR 2010 0070042 A bekannt. Einen ähnlichen Filterlüfter beschreibt auch die DE 201 07 242 U1. Aus der DE 10 2010 016 504 A1 ist eine Filtereinheit für einen Schaltschrank bekannt und aus der WO 2011/054784 A1 Superabsorber enthaltende Textilien.

Die aus dem Stand der Technik bekannten Lufteintritts- oder Luftaustrittsfilter haben den Nachteil, dass sie in Bezug auf die erzielbare IP-Schutzklasse eines Schaltschrankgehäuses, in welchem sie verbaut sind, eine Schwachstelle darstellen, da die Lufteintritts- oder Luftaustrittsfilter aufgrund ihrer Luftdurchlässigkeit naturgemäß auch eine gewisse Durchlässigkeit für Flüssigkeit aufweisen, wenn der Lufteintritts-oder Luftaustrittsfilter über längere Zeit oder mit einem erheblichen Flüssigkeitsvolumenstrom beaufschlagt wird.

Es ist daher die Aufgabe der Erfindung, eine Schaltschrankanordnung der eingangs beschriebenen Art vorzuschlagen, der eine möglichst geringe Durchlässigkeit für Flüssigkeiten aufweist.

Diese Aufgabe wird durch eine Schaltschrankanordnung nach Anspruch 1 gelöst. Vorteilhafte Ausführungsformen der Erfindung sind jeweils Gegenstand der abhängigen Ansprüche.

Der Vliesstoff der Absorbermatte kann von sich aus absorbierende Eigenschaften in Bezug auf Flüssigkeit, vorzugsweise Wasser, und/oder einen Superabsorber aufweisen, wobei der Superabsorber in dem Vliesstoff aufgenommen oder der Vliesstoff mit dem Superabsorber beschichtet sein kann.

Der Faltenfilter kann den Vliesstoff aufweisen, mithin können Faltenfilter und Absorbermatte einteilig ausgebildet oder dasselbe Bauteil sein. Der Vliesstoff kann auch zusätzlich zu dem Faltenfilter bereitgestellt sein und den Luftdurchlassquerschnitt des Filtergehäuses bedecken.

Der Vliesstoff flüssigkeitsabsorbierend und/oder hydrophob sein. Der Vliesstoff besteht vorzugsweise aus thermisch und/oder mechanisch gebundenen Polyesterfasern. Die Fasern des Vliesstoffs können hydrophob sein, während das aus den hydrophoben Fasern gebildete Vlies (non-woven) wasserabsorbierende Eigenschaften aufweisen kann.

Zumindest in dem Fall, dass der Vliesstoff hydrophob ist, kann der Vliesstoff und/oder der Faltenfilter an einer Unterseite einen flüssigkeitsabsorbierenden Materialstreifen, vorzugsweise einen hydrophilen Vliessteifen aufweisen. Aufgrund der hydrophoben Eigenschaften des Vliesstoffs an dem Vliesstoff in vertikaler Richtung ablaufendes Wasser kann in dem flüssigkeitabsorbierenden Materialstreifen absorbiert werden.

Der flüssigkeitsabsorbierenden Materialstreifen kann außerhalb des Luftdurchlassquerschnitts des Filtergehäuses angeordnet sein. Das von dem Materialstreifen absorbierte Flüssigkeitsvolumen wird somit außerhalb des Querschnitts vorgehalten und damit ein zusätzlicher Schutz vor dem versehentlichen Eindringen der Flüssigkeit in das Schaltschrankgehäuse bereitgestellt.

Der Vliesstoff der Absorbermatte kann ein Flächengewicht von weniger als 250 g/m², vorzugsweise von weniger als 200 g/m² und besonders bevorzugt weniger als 180 g/m² aufweisen. Dadurch kann der Druckverlust der Absorbermatte auf ein unbedeutendes Maß herabgesetzt werden. Die Absorbermatte aus Vliesstoff kann bei einem Lufteintrittsfilter in Strömungsrichtung stromabwärts zu dem Faltenfilter und bei einem Luftaustrittsfilter in Strömungsrichtung stromaufwärts zu dem Faltenfilter angeordnet sein. Die Absorbermatte aus Vliesstoff kann angrenzend an den Faltenfilter oder unter einem Abstand zu dem Faltenfilter angeordnet sein.

Bei der Verwendung eines Superabsorbers hat dieser die Eigenschaft, dass er bei Beaufschlagung mit Flüssigkeit sein Volumen (stark) erhöht und damit die Durchlässigkeit des Filtersubstrats für jegliches Fluid herabsetzt. Je nach Konzentration des in dem Filtersubstrat enthaltenen Superabsorbers ist sogar denkbar, dass der Superabsorber im aufgequollenen Zustand (Hydrogel) das Filtersubstrat vollständig blockiert und damit den Lufteintritts- oder Luftaustrittsfilter bei den üblichen Druckdifferenzen (etwa eines Filterlüfters) faktisch luftundurchlässig macht.

Das Filtersubstrat kann von dem Superabsorber durchsetzt oder mit diesem beschichtet sein. Wenn das Filtersubstrat ein Vlies ist, kann ein granular bereitgestellter Superabsorber von den Fasern des Vliesmaterials gehalten sein. Es kann ein Bindemittel vorgesehen sein, um den Superabsorber an dem Vliesmaterial zu halten. Vorzugsweise ist der Superabsorber nicht in oder auf dem Faltenfilter bereitgestellt. Stattdessen kann das Filtersubstrat einen zusätzlichen Vliesstoff aufweisen, der mit dem Superabsorber beschichtet ist, oder in dem der Superabsorber aufgenommen ist. Der Vliesstoff kann als ein separater Bestandteil des Filtersubstrats unabhängig von dem Faltenfilter oder im Verbund mit dem Faltenfilter bereitgestellt sein.

Der Faltenfilter kann den Vliesstoff der flüssigkeitsabsorbierenden Matte aufweisen oder der Vliesstoff der flüssigkeitsabsorbierenden Matte kann zusätzlich zu dem Faltenfilter als ein den Luftdurchlassquerschnitt des Filtergehäuses bedeckender Vliesstoff bereitgestellt sein. In dem Vliesstoff kann der Superabsorber aufgenommen sein. Alternativ kann der Vliesstoff mit dem Superabsorber beschichtet sein. Es ist auch denkbar, dass der Vliesstoff sowohl von dem Superabsorber durchsetzt als auch mit dem Superabsorber beschichtet ist. Unabhängig von dem den Superabsorber aufweisenden Vliesstoff kann auch der Faltenfilter aus einem Vliesstoff bestehen, mithin ein handelsüblicher Faltenfilter für die Verwendung in Lufteintritts- oder Luftaustrittsfiltern, etwa eines Filterlüfters, sein.

Der Vliesstoff kann mit dem Superabsorber als Granulat beschichtet und/oder durchsetzt sein, wobei das Granulat von Fasern des Vliesstoffs oder von einem Bindemittel an den Fasern gehalten ist.

Um zu vermeiden, dass bei einer Beaufschlagung des Lufteintritts- oder Luftaustrittsfilters mit einer Flüssigkeit das Filtersubstrat aufgrund des aufquellenden Superabsorbers vollständig blockiert und damit insbesondere auch die für die Kühlung der in dem Schaltschrankgehäuse aufgenommenen Komponenten erforderliche Frischluft in das Schaltschrankinnere nicht mehr hineintransportiert werden kann, ist bei einer besonderen Ausführungsform der Erfindung vorgesehen, dass der Vliesstoff den Superabsorber nur innerhalb eines Anteils des Luftdurchlassquerschnitts des Filtergehäuses aufweist, wobei der Anteil vorzugsweise weniger als 50 % des Luftdurchlassquerschnitts beträgt. Der Anteil mit dem Superabsorber kann insbesondere in einem unteren Bereich des Vliesstoffs bereitgestellt sein. Dort kann sich beispielsweise an einem das Filtersubstrat bedeckenden Lamellengitters ablaufendes Regenwasser ansammelt. Sodass der Lufteintritts- oder Luftaustrittsfilter an dieser Stelle besonders anfällig für den Eintritt von Flüssigkeit in das Schaltschrankinnere ist, die beispielsweise von einem Luftstrom mitgerissen wird, der von einem Lüfter eines Lufteintrittsfilters, mithin von einem Filterlüfter, erzeugt wird.

Der Superabsorber kann somit ausschließlich in einem in der Einbaulage des Lufteintritts- oder Luftaustrittsfilters an einem Schaltschrankgehäuse unteren Bereich des Vliesstoffs angeordnet sein. Insbesondere kann ein in Bezug auf den unteren Bereich oberer Bereich des Vliesstoffs frei von dem Superabsorber sein.

Der Superabsorber kann in einem kristallinen Zustand in dem Vliesstoff oder an dem Vliesstoff bereitgestellt sein, wobei der Superabsorber in einem aufgequollenen Zustand als Hydrogel ein Volumen aufweist, das mindestens 40 mal, vorzugsweise mindestens 70 mal und besonders bevorzugt mindestens 100 mal großer als das Volumen im kristallinen Zustand ist.

Der Vliesstoff kann eine Sandwichstruktur aufweisen, mit einem ersten und einem zweiten äußeren Filtervlies, zwischen denen eine den Superabsorber aufweisende Absorberschicht angeordnet ist. Bei dieser Ausführungsform können insbesondere die beiden äußeren Filtervliese frei von Superabsorber sein. Die Absorberschicht kann ein von dem Filtersubstrat unabhängiges, weiteres Filtervlies sein, das den Superabsorber aufweist.

Vorzugsweise weist das Filtersubstrat den Faltenfilter und die Absorbermatte als separate Komponenten auf, die beispielsweise aufeinanderliegend in das Gehäuse des Lufteintritts- oder Luftaustrittsfilters eingelegt werden können. Dieses Filtersubstrat ist insbesondere auch für als Filterlüfter ausgebildete Lufteintrittsfilter mit horizontalem oder vertikalem Lamellengitter geeignet. Der Faltenfilter dient dabei der Filtration kann mit seiner im Vergleich zu herkömmlichen Vliesfiltern größeren Oberfläche zur Steigerung des Volumenstroms des Filterlüfters beitragen. Dabei können bisher Schutzarten von IP55 entweder nur mit einer aufwendigen, mechanischen LabyrinthDichtung oder mit zwei engmaschig hintereinanderliegenden Vliesfiltern realisiert werden. Die Absorbermatte hingegen dient als Wasserabscheider und sorgt dafür, dass insbesondere bei Filterlüftern kein Wasser bei laufendem/saugendem Lüftermotor in den Schaltschrank gelangt.

Wenn das Filtersubstrat den Faltenfilter und die Absorbermatte als separate Komponenten aufweist, können diese unter einem Abstand zueinander angeordnet sein. Dadurch wird die Übertragung der durch den Faltenfilter hindurchtretenden Flüssigkeit auf die Absorbermatte herabgesetzt und diese dadurch weniger stark belastet. Dieser positive Effekt kann dadurch noch verstärkt werden, dass der Faltenfilter und die Absorbermatte nicht parallel, d.h. unter einem spitzen Winkel zueinander angeordnet sind. Dabei ist vorzugsweise der Faltenfilter parallel zum Luftdurchlassquerschnitt ausgerichtet und die Absorbermatte dazu angewinkelt, beispielsweise um 5 bis 15°.

Es wird eine Schaltschrankanordnung mit einem Schaltschrankgehäuse und mindestens einem Lufteintritts- oder Luftaustrittsfilter beschrieben. Bei dem mindestens einen Lufteintritts- oder Luftaustrittsfilter ist das Filtergehäuse in einer vertikalen Gehäusewand des Schaltschrankgehäuses montiert und weist an einer Außenseite des Schaltschrankgehäuses ein Lamellengitter auf.

Das Lamellengitter weist eine Vielzahl sich vertikal erstreckender Lamellen auf oder besteht aus einer Vielzahl sich vertikal und parallel zueinander erstreckender Lamellen.

Das Filtergehäuse kann eine das Lamellengitter aufweisende und gegenüber einem in der Gehäusewand festgelegten Filtergehäuseunterteil verschwenkbare oder von diesem abnehmbare Filtergehäuseabdeckung aufweisen. Das Filtersubstrat kann zwischen dem Filtergehäuseunterteil und der Filtergehäuseabdeckung aufgenommen sein. Um den Wechsel des Filtersubstrats zu erleichtern, kann das Filtersubstrat in einer Aufnahme der Filtergehäuseabdeckung gehalten sein. Bei einer Ausführungsform ist der Faltenfilter des Filtersubstrats in der Filtergehäuseabdeckung gehalten, während ein Vliesstoff mit dem darin aufgenommenen oder dem darauf beschichteten Superabsorber in dem Filtergehäuseunterteil gehalten ist.

Bei einem mehrteiligen Filtersubstrat bestehend aus einem Faltenfilter und einem gesonderten, den Superabsorber aufweisenden Vliesstoff kann bei einem turnusmäßigen Wechsel des Filtersubstrats zur Vermeidung einer Blockierung des Filtersubstrats durch die aus der Umgebungsluft herausgefilterten Partikel lediglich der Faltenfilter ausgetauscht werden, da der Vliesstoff keinem oder nur einem wesentlich geringeren Verschleiß im Vergleich zu dem Faltenfilter unterliegt. Mehrteilige Filtersubstrate sind daher besonders ressourcenschonend.

Das Filtergehäuse kann eine das Lamellengitter aufweisende und gegenüber einem Filtergehäuseunterteil verschwenkbare oder von diesem abnehmbare Filtergehäuseabdeckung aufweisen, in der der Faltenfilter mit dem Vliesstoff und dem darin aufgenommenen Superabsorber gehalten ist.

Der Faltenfilter ist im Innern des Filtergehäuses dem Lamellengitter zugewandt angeordnet, wobei sich die Lamellen parallel zu den Falten des Faltenfilters erstrecken, so dass zwischen benachbarten Falten des Faltenfilters jeweils ein vertikal verlaufender und zu dem Lamellengitter hin geöffneter Kanal gebildet ist, welcher die Ableitung von Flüssigkeit, mit welcher der Lufteintritts- oder Luftaustrittsfilter beaufschlagt wird, fördert.

Bei einer Ausführungsform kann die Schaltschrankanordnung einen Lufteintrittsfilter und einen Luftaustrittsfilter der zuvor beschriebenen Art aufweisen, wobei der Lufteintrittsfilter als ein Filterlüfter ausgebildet ist. Der grundsätzliche Aufbau eines Filterlüfters ist in der DE 10 2010 016 504 A1 beschrieben.

Ein Verfahren für den Betrieb einer Schaltschrankanordnung der zuvor beschriebenen Art beschrieben kann das Ansaugen von Umgebungsluft durch den Lufteintrittsfilter in das Schaltschrankgehäuse, das Hindurchleiten der Umgebungsluft durch das Schaltschrankgehäuse und das Ausblasen der Umgebungsluft durch den Luftaustrittsfilter aufweisen. Das Verfahren weist weiterhin das Beaufschlagen des Lufteintritts- und/oder des Luftaustrittsfilters mit Flüssigkeit auf, vorzugsweise mit Regen oder Spritzwasser.

Wenn die Flüssigkeit in den Lufteintritts- und/oder den Luftaustrittsfilter eindringt und dort mit einem Superabsorber in Kontakt tritt, quillt der Superabsorber auf und wird in ein Hydrogel umgewandelt, woraufhin der Superabsorber den Luftdurchlassquerschnitt des Filtergehäuses des betreffenden Lufteintritts- und/oder Luftaustrittsfilters herabsetzt oder den Luftdurchlassquerschnitt des Filtergehäuses vollständig blockiert. Wenn die Absorbermatte keinen Superabsorber aufweist, kann die Flüssigkeit in der Absorbermatte gespeichert werden und/oder von dieser an einer unteren Horizontalkante abgeleitet werden, beispielsweise abtropfen. Alternativ kann die Flüssigkeit in einem flüssigkeitsaufsaugenden Vliesstreifen an der Faltenfilterunterseite gespeichert werden. Der flüssigkeitsaufsaugenden Vliesstreifen kann bei einer Ausführungsform einen Superabsorber aufweisen.

Die Absorbermatte kann auch ohne die Verwendung absorbierender Zusatzstoffe wie Superabsorbern wasserabsorbierende Eigenschaften aufweisen. Dazu kann das Material des Vliesstoffs, insbesondere die Fasern, etwa Polyesterfasern, stark hydrophob ausgebildet sein und/oder eine absorbierende Eigenschaft aufweisen. Wenn der Lufteintritts- und/oder den Luftaustrittsfilter mit Flüssigkeit beaufschlagt wird, kann die Flüssigkeit auf den vorzugsweise vertikal eingesetzten Faltenfilter treffen. Durch diese Anordnung können die Bereiche zwischen den Falten einen vertikalen Führungskanal zu einem Ablauf aus dem Filterlüfter bilden.

Trifft nun ein Strahl mit ausreichend hoher Energie auf den Faltenfilter auf, können Tropfen durch den Faltenfilter auf die Schaltschrankinnenseite gelangen. Nun kommt die optionale hydrophobe Wirkung der Absorbermatte zum Tragen. Die Tropfen perlen von der Oberfläche ab und laufen nach unten ab, wo sie unter dem Faltenfilter nach Außen ablaufen können. Die Faltenfilterunterseite einen flüssigkeitsaufsaugenden Vliesstreifen aufweisen. Es kann vorkommen, dass einzelne Bereiche des Faltenfilters soweit mit Wasser gesättigt werde, dass Tröpfchen durch die Sogwirkung eines optionalen Lüfters des Lufteintritts- und/oder des Luftaustrittsfilters in Richtung Schrankinnenseite gezogen werden.

Nun kann die Absorberwirkung der Absorbermatte zum Tragen kommen. Die Tröpfchen können in den Fasern der Absorbermatte gebunden werden und gelangen auch bei laufendem Lüfter nicht in den Schaltschrank. Durch die Absorption wird temporär durch Verschluss einzelner Teilbereiche der aktiven Filterfläche der Volumenstrom gemindert und trägt damit zusätzlich positiv zum Bestehen einer IP-Schutzklassenanforderung bei. In Ermangelung von Absorberstoffen wie Superabsorbern kann die Absorbermatte einfach ausgeklopft werden, und ist sofort wieder zu verwenden. Alternativ kann die Wiederverwendung der Absorbermatte nach dem Verdunsten des absorbierten Wassers im Lufteintritts- und/oder Luftaustrittsfilter erfolgen. Die dabei entstehende Verdunstungskälte kann den mitunter temporär verminderten Luftvolumenstrom aufgrund der Flüssigkeitsabsorption kompensieren. Damit ist diese Ausführungsform auch im Vergleich zu den aus dem Stand der Technik bekannten Lösungen reversibel.

Aus dem Stand der Technik bekannte Filtersubstrate mit mindestens zwei Lagen Vliesfiltern haben den Nachteil, einen hohen Differenzdruck zu erzeugen, so dass die Hauptfunktion des Lufteintritts- und/oder Luftaustrittsfilters, die Kühlung mit Umgebungsluft stark gemindert wird. Nach dem Wassereintrag sind die Vliesfilter so mit Flüssigkeit gesättigt, dass diese Flüssigkeit in den Schrank eintreten kann. Die Filtersubstrate müssen daher zwingend getauscht werden. Hinzu kommt, das sich aufgrund der engmaschigen Fasern diese Filterkombinationen schneller mit Staub zusetzen, wodurch kurze Wartungsintervalle notwendig sind.

Der Faltenfilter wird vorzugsweise vertikal in das Filtergehäuse eingesetzt. An den Seiten können Laschen angeordnet sein, die zum einen das Einlegen in das Filtergehäuse erleichtern und zum anderen die Aufgabe einer seitlichen Dichtung übernehmen. An einer oberen oder unteren Längskante kann der Faltenfilter jeweils einen Vliesstreifen aufweisen. Dieser weist zum einen eine Dichtwirkung gegenüber dem Filtergehäuse auf und ermöglicht im unteren Bereich des Filtergehäuses das Ablaufen der Flüssigkeit.

Weitere Einzelheiten der Erfindung werden anhand der nachstehenden Figuren erläutert. Dabei zeigt:
- Figur 1: eine beispielhafte Ausführungsform eines Lufteintritts- oder Luftaustrittsfilters gemäß dem Stand der Technik;
- Figur 2: eine Detailansicht eines Filtergehäuses im aufgeklappten Zustand gemäß einer Ausführungsform der Erfindung;
- Figur 3: eine schematische Draufsicht auf ein Filtersubstrat gemäß einer Ausführungsform der Erfindung;
- Figur 4: eine Querschnittsansicht eines Vliesstoffs gemäß einer Ausführungsform der Erfindung;
- Figur 5: eine Detailansicht einer Schaltschrankanordnung gemäß einer Ausführungsform der Erfindung; und
- Figur 6: zwei Ausführungsformen einer mehrteiligen Filtersubstrats.

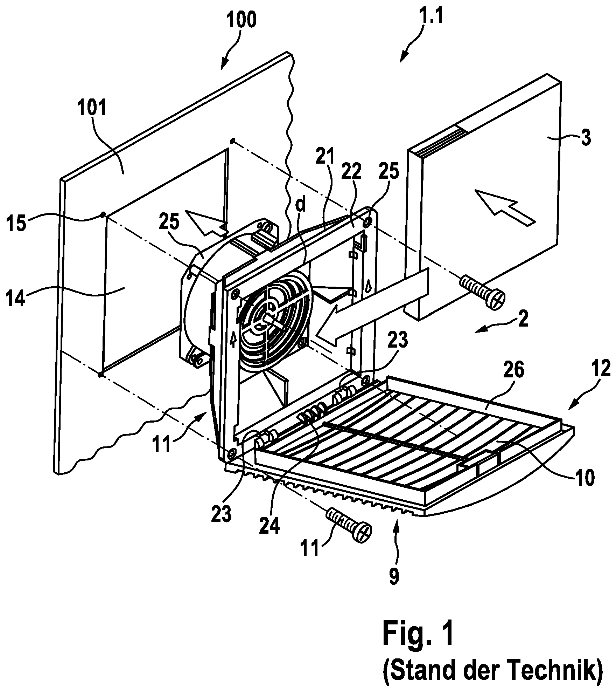

Die Figur 1 zeigt einen beispielhaften Lufteintrittsfilter 1.1 gemäß dem Stand der Technik. Der Lufteintrittsfilter 1.1 ist in ein Wandelement eingesetzt, das vorliegend als eine vertikale Gehäusewand 101 ausgebildet ist. Die vertikale Gehäusewand 101 kann beispielsweise eine Seitenwand, eine Rückwand oder eine frontseitige Tür des Schaltschrankgehäuses 100 sein. Die Gehäusewand 101 weist einen quadratischen Durchbruch 14 auf, dem in den Eckbereichen Schraubaufnahmen 15 zugeordnet sind. In den Durchbruch 14 kann der Lufteintrittsfilter 1.1 eingesetzt werden. Vorliegend weist der Lufteintrittsfilter 1.1 ein Filtergehäuse 2 auf, das mit einer Gehäusewandung 21 des Filtergehäuseunterteils 11 einen Luftführungsbereich umschließt und den Luftdurchlassquerschnitt d des Filtergehäuses 2 festlegt. An dem Boden des Filtergehäuseunterteils 11 ist ein Lüfter 25 angeflanscht. Der Lüfter 25 weist einen Elektromotor und einen Ventilator auf, der dazu eingerichtet ist, Umgebungsluft anzusaugen und in den Schaltschrankinnenraum 1 zu blasen, wie dies durch die Pfeildarstellung in Figur 1 symbolisiert ist. Dem Lüfter 25 abgekehrt ist an die Gehäusewandung 21 ein umlaufender Bund 22 angeformt. Mittels des Bundes 22 kann die Einsetzbewegung des Filtergehäuses 2 in den Durchbruch 14 begrenzt werden. Dabei liegt dann der Bund 22 frontseitig um den Durchbruch 14 herum auf der Gehäusewand 101 auf. Der Bund 22 weist in seinen Eckbereichen Schraubaufnahmen 15 auf. Durch diese können Befestigungsschrauben 16 hindurchgeführt und in die Schraubaufnahmen 15 der Gehäusewand 101 eingeschraubt werden. Auf diese Weise ist das Filtergehäuse 2 fest mit der Gehäusewand 101 verbunden.

Wie Figur 1 weiter erkennen lässt, weist das Filtergehäuse 2 neben dem Filtergehäuseunterteil 11 eine Filtergehäuseabdeckung 12 auf, die im Wesentlichen als ein Luftdurchtrittsgitter ausgebildet ist. Das Luftdurchtrittsgitter ist dabei über zwei Scharniere 23 an seinem unteren horizontalen Rand an dem unteren horizontalen Rand des Filtergehäuseunterteils 11 gekoppelt. Die Scharniere 23 bilden eine horizontale Scharnierachse, um die das Luftdurchtrittsgitter bzw. die Filtergehäuseabdeckung 12 zwischen einer senkrechten Montageposition und einer, in Figur 1 dargestellten, abgeklappten Wartungsposition, verstellbar ist.

Die Filtergehäuseabdeckung 12 weist drei ineinander übergehende Wände auf, die einen Filterhalter 26 für das Filtersubstrat 3 bilden. In den Filterhalter 26 kann das Filtersubstrat 3 eingelegt werden. Dabei stützt sich das Filtersubstrat 3 mit seiner Vorderseite auf Lamellen 10 des Durchtrittsgitters. Die Lamellen 10 bilden Lufteintrittsöffnungen, durch die Umgebungsluft durch das Filtersubstrat 3 hindurch in das Filtergehäuse 2 und den Lüfter 25 in das Schaltschrankgehäuse 100 hineingefördert werden kann.

Bei den aus dem Stand der Technik bekannten Lufteintrittsfiltern und entsprechenden Luftaustrittsfiltern (nicht dargestellt) sind die Filtersubstrate häufig als Filtermatten aus einem Vliesmaterial oder als Faltenfilter aus Vliesmaterial ausgebildet.

Die bekannten Lufteintrittsfilter 1.1 und entsprechende Luftaustrittsfilter (nicht dargestellt) haben demgemäß den Nachteil, dass sich bei einer Beaufschlagung des Lamellengitters 9 der Filtergehäuseabdeckung 12 mit Flüssigkeit die Filtermatte 3 mit Flüssigkeit vollsaugt und die Flüssigkeit ggf. zumindest im Falle eines Lufteintrittsfilters 1.1 aufgrund des von dem Lüfter 25 bereitgestellten Unterdrucks in das Schaltschrankinnere hineingesogen wird, wo schon aufgrund der in dem Schaltschrankinnern mitunter enthaltenen feuchtigkeitsempfindlichen elektrischen Komponenten der Flüssigkeitseintritt unerwünscht ist. Dementsprechend sind Lufteintrittsfilter und entsprechende Luftaustrittsfilter der wesentliche Schwachpunkt bei der Erzielung hoher IP-Schutzklassen im Schaltanlagenbau.

Demgemäß ist bei einem erfindungsgemäßen Lufteintrittsfilter vorgesehen, dass das in dem Filtergehäuse aufgenommene Filtersubstrat 3 neben einem Falterfilter weiterhin eine Absorbermatte aus einem Vliesstoff aufweist.

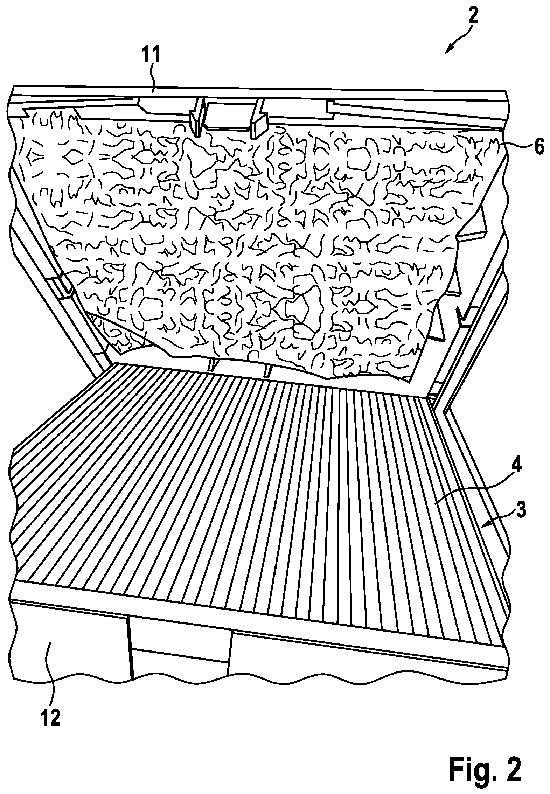

Die Figur 2 zeigt eine beispielhafte Ausführungsform eines derartigen Filtergehäuses 2, wobei das Filtersubstrat 3 mehrteilig ausgebildet ist, mit einem Faltenfilter 4, der analog zu der Ausführungsform aus dem Stand der Technik gemäß Figur 1 in der Filtergehäuseabdeckung 12 aufgenommen ist, und einem zusätzlichen Vliesstoff 6, der als die Absorbermatte bildet, welche in dem Filtergehäuseunterteil 11 aufgenommen ist und optional einen Superabsorber aufweisen kann. Im zusammengeklappten Zustand, d.h. wenn die Filtergehäuseabdeckung 12 an dem Filtergehäuseunterteil 11 anliegt und die angedeutete Rastverbindung an dem Filtergehäuseunterteil 11 festgelegt ist, erstrecken sich der Faltenfilter 4 und der Vliesstoff 6 im Wesentlichen parallel zu einander, wobei der Faltenfilter 4 und der Vliesstoff 6 unmittelbar aufeinanderliegend und aneinandergrenzend ausgebildet sein können. Alternativ können sie auch beabstandet voneinander sein, um die Überleitung von Flüssigkeit von dem Faltenfilter auf den Vliesstoff 6 der Absorbermatte zu verhindern und damit die Belastung der Absorbermatte mit Flüssigkeit herabzusetzen, so dass dieser länger durchlässig für Luft bleibt und damit der Lufteintritts-oder Luftaustrittsfilter seine originäre Funktion weiter aufrechterhalten kann.

Wenn demgemäß bei einer Flüssigkeitsbeaufschlagung des Lamellengitters (nicht dargestellt) der Filtergehäuseabdeckung 12 Flüssigkeit durch den Faltenfilter 4 hindurchtritt (welcher aufgrund seiner Faltengeometrie gegenüber klassischen Filtermatten bereits eine bessere Flüssigkeitsableitung aufweist), trifft die Flüssigkeit auf den Vliesstoff 6 der Absorbermatte. Wenn die Absorbermatte einen Superabsorber aufweist, kann auch dieser die Flüssigkeit aufnehmen und aufgrund seiner Volumenvergrößerung den Vliesstoff 6 blockieren, so dass zusätzliche Flüssigkeit, welche eventuell von der Absorbermatte nicht mehr aufgenommen werden kann, nicht mehr durch den Vliesstoff 6 in das Schaltschrankinnere gelangen kann.

Der Vliesstoff 6 kann mit dem optionalen Superabsorber beschichtet sein oder von dem Superabsorber durchtränkt sein. Der Superabsorber kann als ein Granulat bereitgestellt sein, welches eine Korngröße aufweist, die insoweit auf den Vliesstoff 6 abgestimmt ist, dass die Fasern den Superabsorber halten können, ohne dass ein zusätzliches Bindemittel oder ein Haftvermittler erforderlich sind. Der Superabsorber kann jedoch auch mit einem Haftvermittler auf den Vliesstoff 6 beschichtet sein oder in dem Vliesstoff 6 verankert sein.

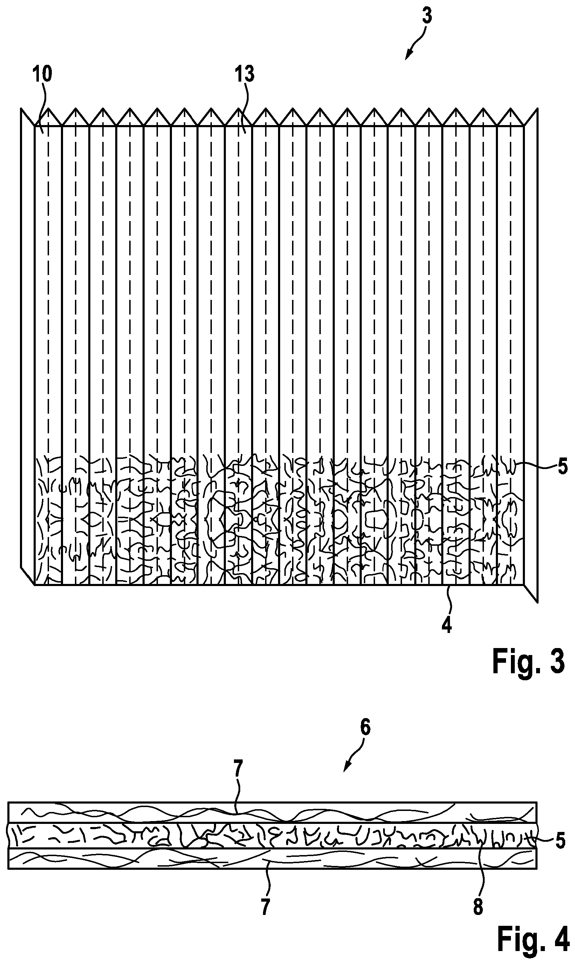

Die Figur 3 zeigt eine Ausführungsform eines Filtersubstrats 3, bei dem der Faltenfilter 4 lediglich in einem in vertikaler Richtung unteren Bereich den Superabsorber 5 aufweist, während ein darüber liegender Bereich frei von dem Superabsorber 5 ist. Insbesondere kann lediglich in einem unteren Drittel oder in einem unteren Viertel des Filtersubstrats 3 der Superabsorber 5 vorgesehen sein. Analog zu der Ausführungsform gemäß Figur 2 kann der Superabsorber 5 in Form eines zusätzlichen Vliesstoffs 6 bereitgestellt sein. Alternativ kann der Superabsorber 5 auch unmittelbar auf den Faltenfilter 4 aufgebracht sein, beispielsweise auf diesen beschichtet sein oder von diesem durchtränkt sein.

Ebenfalls angedeutet sind die Lamellen 10 des nicht dargestellten Lamellengitters der Filtergehäuseabdeckung. Wie zu erkennen ist, sind auch die Lamellen 10, abweichend von den aus dem Stand der Technik bekannten Lufteintrittsfiltern und Luftaustrittsfiltern vertikal ausgerichtet und parallel zu den Falten des Faltenfilters 4. Auf diese Weise bilden die parallelen Falten des Faltenfilters vertikale Kanäle 13, die für die Abführung von Flüssigkeit verwendet werden können. Dies kommt insbesondere dann zum Tragen, wenn aufgrund bereits erfolgter Flüssigkeitsbeaufschlagung der Faltenfilter 4 zumindest teilweise blockiert ist und unmittelbar an dem Faltenfilter anfallende Flüssigkeit kanalisiert werden muss, weil sie nicht mehr durch den Faltenfilter hindurchtreten kann.

Die Figur 4 zeigt eine weitere Ausführungsform eines mehrschichtigen Vliesstoffs 6 bestehend aus zwei äußeren Filtervliesen 6, die frei von Superabsorber sind und einer zwischen diesen angeordneten Absorberschicht, die den Superabsorber 5 aufweist.

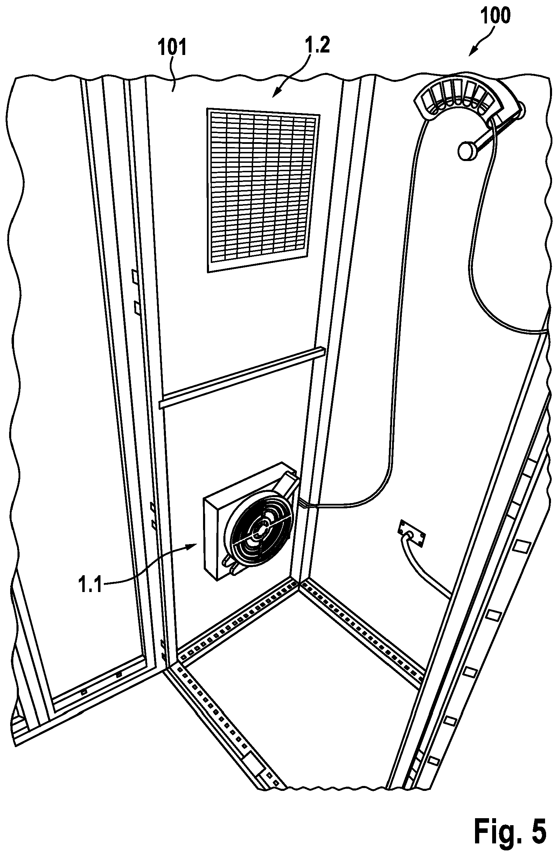

Die Figur 5 zeigt Ein Schaltschrankgehäuse 100, bei dem in einer Seitenwand 101 vertikal übereinander ein Lufteintrittsfilter 1.1 und ein Luftaustrittsfilter 1.2 angeordnet sind. Bei geschlossener Schaltschranktür steht das im Schaltschrankinnern aufgenommene Luftvolumen im Wesentlichen ausschließlich über die beiden Lufteintritts- und Luftaustrittsfilter 1.1, 1.2 mit der Umgebung des Schaltschrankgehäuses 100 fluidisch in Verbindung. Demgemäß kann über den als Filterlüfter ausgebildeten Lufteintrittsfilter 1.1 Umgebungsluft durch den Lufteintrittsfilter 1.1 in das Schaltschrankgehäuse 100 angesogen werden. Die angesogene Umgebungsluft kann durch das Schaltschrankgehäuse 100 hindurch geleitet und durch den Luftaustrittsfilter 1.2 zurück in die Umgebung des Schaltschrankgehäuses 100 ausgeblasen werden. Wenn der Lufteintritts- und/oder der Luftaustrittsfilter 1.1, 1.2 mit Flüssigkeit, beispielsweise mit Regen oder Spritzwasser, beaufschlagt wird, kann die Flüssigkeit in den Lufteintrittsfilter 1.1- und/oder den Luftaustrittsfilter 1.2 eindringen und mit dem Superabsorber des Filtersubstrats in Kontakt treten, woraufhin der Superabsorber 5 aufquillt und in ein Hydrogel umgewandelt wird. Daraufhin kann der Superabsorber den Luftdurchlassquerschnitt des Filtergehäuses des betreffenden Lufteintritts- und/oder Luftaustrittsfilter herabsetzen oder vollständig blockieren, sodass der Eintritt von Flüssigkeit in das Schaltschrankgehäuse unterbunden oder zumindest deutlich herabgesetzt wird.

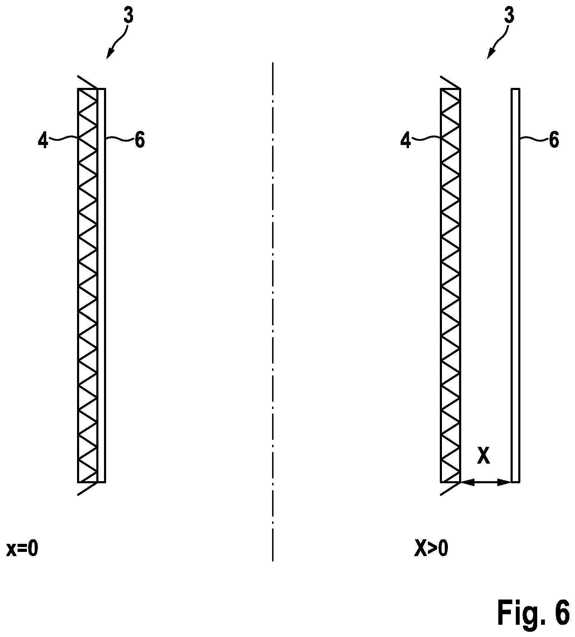

Die Figur 6 zeigt zwei Ausführungsformen eines mehrteiligen Filtersubstrats 3 mit einem Faltenfilter 4 und einer separaten Absorbermatte in Form eines Vliesstoffs 6. Bei der ersten Ausführungsform (links) liegt die Absorbermatte unmittelbar auf dem Faltenfilter 4 auf. Vorzugsweise ist die Absorbermatte in Luftströmungsrichtung durch das Filtersubstrat 3 hinter dem Faltenfilter 4 angeordnet.

Im Vergleich dazu ist bei der zweiten Ausführungsform (rechts) die Absorbermatte unter einem Abstand x zu dem Faltenfilter 4 angeordnet. Analog zu der ersten Ausführungsform ist die Absorbermatte in Luftströmungsrichtung durch das Filtersubstrat 3 hinter dem Faltenfilter 4 angeordnet. Die Beanstandung hat den Vorteil, dass die Übertragung von Flüssigkeit von dem Faltenfilter 4 auf die Absorbermatte erschwert wird, wodurch die Flüssigkeitsbelastung des Vliesstoffs 6 herabgesetzt wird. Dadurch kann die Standzeit der Absorbermatte erhöht werden.

Vorzugsweise ist die Absorbermatte, wie dargestellt, parallel beabstandet zu dem Faltenfilter 4 angeordnet. Bei einer Ausführungsform kann die Absorbermatte jedoch auch unter einem Winkel, vorzugsweise einem spitzen Winkel, zu dem Faltenfilter 4 angeordnet sein. Dabei ist der Faltenfilter 4 vorzugsweise vertikal ausgerichtet und die Absorbermatte hierzu aus der Vertikalen verkippt, beispielsweise um 5° bis 15°. Diese Verkippung der Absorbermatte hat den Vorteil, dass die Absorbermatte mit einer größeren Fläche in dem Filtergehäuse verbaut werden kann und damit die Strömungsgeschwindigkeit durch die Absorbermatte herabgesetzt ist, wodurch das Eintreten von Flüssigkeit in das Schaltschrankinnere im Sättigungsfall der Absorbermatte erschwert wird. Insbesondere bei hydrophoben Absorbermatten, beispielsweise aus hydrophoben Polyesterfasern, kann bei einer angewinkelten Absorbermatte die in der Absorbermatte gespeicherte Flüssigkeit besser vertikal abtropfen.

Die in der vorstehenden Beschreibung, in der Zeichnung sowie in den Ansprüchen offenbarten Merkmale der Erfindung können sowohl einzeln als auch in beliebiger Kombination für die Verwirklichung der Erfindung wesentlich sein.

### Bezugszeichenliste

- 1.1: Lufteintrittsfilter
- 1.2: Luftaustrittsfilter
- 2: Filtergehäuse
- 3: Filtersubstrat
- 4: Faltenfilter
- 5: Superabsorber
- 6: Vliesstoff
- 7: äußeres Filtervlies
- 8: Absorberschicht
- 9: Lamellengitter
- 10: Lamelle
- 11: Filtergehäuseunterteil
- 12: Filtergehäuseabdeckung
- 13: Kanal
- 14: Durchbruch
- 15: Schraubaufnahme
- 16: Befestigungsschraube
- 21: Gehäusewand
- 22: Umlaufender Bund
- 23: Scharnier
- 24: Halter
- 25: Lüfter
- 26: Filterhalter
- 100: Schaltschrankgehäuse
- 101: Gehäusewand
- d: Luftdurchlassquerschnitt
- x: Abstand

## Patentansprüche

1. Schaltschrankanordnung mit einem Schaltschrankgehäuse (100) und mindestens einem Lufteintritts- oder Luftaustrittsfilter (1.1, 1.2), der ein Filtergehäuse (2) aufweist, das in einer vertikalen Gehäusewand (101) des Schaltschrankgehäuses (100) montiert ist und an einer Außenseite (102) des Schaltschrankgehäuses (100) ein Lamellengitter (9) aufweist, wobei in dem Filtergehäuse (2) ein Filtersubstrat (3) mit einem Faltenfilter (4) angeordnet ist, das einen Luftdurchlassquerschnitt (d) des Filtergehäuses (2) vollständig bedeckt und eine flüssigkeitsabsorbierende Absorbermatte aus Vliesstoff (6) aufweist, **dadurch gekennzeichnet, dass** das Lamellengitter (9) eine Vielzahl sich vertikal erstreckender Lamellen (10) aufweist oder aus einer Vielzahl sich vertikal und parallel zueinander erstreckender Lamellen (10) besteht, wobei der Faltenfilter (4) im Innern des Filtergehäuses (2) dem Lamellengitter (9) zugewandt angeordnet ist und sich die Lamellen parallel zu den Falten des Faltenfilters (4) erstrecken, so dass zwischen benachbarten Falten des Faltenfilters (4) jeweils ein vertikal verlaufender und zu dem Lamellengitter (9) hin geöffneter Kanal (13) gebildet ist.

2. Schaltschrankanordnung nach Anspruch 1, bei der der Vliesstoff (6) einen Superabsorber (5) aufweist, wobei der Superabsorber (5) in dem Vliesstoff (6) aufgenommen oder der Vliesstoff (6) mit dem Superabsorber (5) beschichtet ist.

3. Schaltschrankanordnung nach Anspruch 1 oder 2, bei der der Faltenfilter (4) den Vliesstoff (6) aufweist oder der Vliesstoff (6) zusätzlich zu dem Faltenfilter (4) den Luftdurchlassquerschnitt (d) des Filtergehäuses (2) bedeckend bereitgestellt ist.

4. Schaltschrankanordnung nach Anspruch 2 oder 3, bei der der Vliesstoff (6) mit dem Superabsorber (5) als Granulat beschichtet und/oder durchsetzt ist, wobei das Granulat von Fasern des Vliesstoffs (6) oder von einem Bindemittel an den Fasern gehalten ist.

5. Schaltschrankanordnung nach einem der Ansprüche 2 bis 4, bei der der Vliesstoff (6) den Superabsorber (5) nur innerhalb eines Anteils des Luftdurchlassquerschnitts (d) des Filtergehäuses (2) aufweist, wobei der Anteil vorzugsweise weniger als 50 % des Luftdurchlassquerschnitts (d) beträgt.

6. Schaltschrankanordnung nach Anspruch 2 bis 5, bei der der Superabsorber (5) ausschließlich in einem in der Einbaulage des Lufteintritts- oder Luftaustrittsfilter (1.1, 1.2) an einem Schaltschrankgehäuse (100) unteren Bereich des Vliesstoffs (6) angeordnet ist, während ein in Bezug auf den unteren Bereich oberer Bereich des Vliesstoffs (6) frei von dem Superabsorber (5) ist.

7. Schaltschrankanordnung nach einem der Ansprüche 2 bis 5, bei der der Superabsorber (5) in einem kristallinen Zustand in oder an dem Vliesstoff (6) bereitgestellt ist und in einem aufgequollenen Zustand als Hydrogel ein Volumen aufweist, das mindestens 40 mal, vorzugsweise mindestens 70 mal und besonders bevorzugt mindestens 100 mal großer als im kristallinen Zustand ist.

8. Schaltschrankanordnung nach einem der Ansprüche 2 bis 6, bei der der Vliesstoff (6) eine Sandwichstruktur aufweist, mit einem ersten und einem zweiten äußeren Filtervlies (7), zwischen denen eine den Superabsorber (5) aufweisende Absorberschicht (8) angeordnet ist.

9. Schaltschrankanordnung nach Anspruch 7, bei der die Absorberschicht (8) ein von dem Filtersubstrat (3) unabhängiges, weiteres Filtervlies ist, das den Superabsorber (5) aufweist.

10. Schaltschrankanordnung nach einem der vorangegangenen Ansprüche, bei der der Vliesstoff (6) flüssigkeitsabsorbierend und/oder hydrophob ist, wobei der Vliesstoff (6) vorzugsweise aus thermisch und/oder mechanisch gebundenen Polyesterfasern besteht.

11. Schaltschrankanordnung nach Anspruch 10, bei der zumindest in dem Fall, dass der Vliesstoff (6) hydrophob ist, der Vliesstoff (6) und/oder der Faltenfilter (4) an einer Unterseite einen flüssigkeitsabsorbierenden Materialstreifen, vorzugsweise einen hydrophilen Vliessteifen aufweist.

12. Schaltschrankanordnung nach Anspruch 11, bei der der flüssigkeitsabsorbierenden Materialstreifen außerhalb des Luftdurchlassquerschnitts (d) des Filtergehäuses (2) angeordnet ist.

13. Schaltschrankanordnung nach einem der vorangegangenen Ansprüche, bei der der Vliesstoff (6) ein Flächengewicht, von weniger als 250 g/m2, vorzugsweise von weniger als 200 g/m² und besonders bevorzugt weniger als 180 g/m² aufweist.

14. Schaltschrankanordnung nach einem der vorangegangenen Ansprüche, bei der die Absorbermatte aus Vliesstoff (6) bei einem Lufteintrittsfilter (1.1) in Strömungsrichtung stromabwärts zu dem Faltenfilter (4) und bei einem Luftaustrittsfilter in Strömungsrichtung stromaufwärts zu dem Faltenfilter (4) angeordnet ist, wobei die Absorbermatte aus Vliesstoff (6) angrenzend an den Faltenfilter (4) oder unter einem Abstand zu dem Faltenfilter (4) angeordnet ist.

15. Schaltschrankanordnung nach einem der vorangegangenen Ansprüche, bei der das Filtergehäuse (2) eine das Lamellengitter (9) aufweisende und gegenüber einem in der Gehäusewand (101) festgelegten Filtergehäuseunterteil (11) verschwenkbare oder von diesem abnehmbare Filtergehäuseabdeckung (12) aufweist, in der der Faltenfilter (4) gehalten ist, wobei eine Absorbermatte aus Vliesstoff (6) in dem Filtergehäuseunterteil (11) gehalten ist.

16. Schaltschrankanordnung nach einem der vorangegangenen Ansprüche, bei der das Filtergehäuse (2) eine das Lamellengitter (9) aufweisende und gegenüber einem Filtergehäuseunterteil (11) verschwenkbare oder von diesem abnehmbare Filtergehäuseabdeckung (12) aufweist, in der der Faltenfilter (4) und eine Absorbermatte aus Vliesstoff (6) gehalten sind.

## Claims

1. Switch cabinet arrangement having a switch cabinet housing (100) and at least one air inlet or air outlet filter (1.1, 1.2) which has a filter housing (2) which is mounted in a vertical housing wall (101) of the switch cabinet housing (100) and has a lamella grid (9) on an outer side (102) of the switch cabinet housing (100), wherein a filter substrate (3) with a pleated filter (4) is arranged in the filter housing (2), which filter substrate completely covers an air passage cross section (d) of the filter housing (2) and has a liquid-absorbing absorber mat composed of nonwoven fabric (6), **characterized in that** the lamella grid (9) has a multiplicity of vertically extending lamellas (10) or consists of a multiplicity of lamellas (10) which extend vertically and parallel to one another, wherein the pleated filter (4) is arranged in the interior of the filter housing (2) so as to face the lamella grid (9), and the lamellas extend parallel to the pleats of the pleated filter (4), such that a vertically running channel (13) which is open towards the lamella grid (9) is formed in each case between adjacent pleats of the pleated filter (4).

2. Switch cabinet arrangement according to claim 1, in which the nonwoven fabric (6) has a superabsorber (5), wherein the superabsorber (5) is accommodated in the nonwoven fabric (6) or the nonwoven fabric (6) is coated with the superabsorber (5).

3. Switch cabinet arrangement according to claim 1 or 2, in which the pleated filter (4) has the nonwoven fabric (6) or the nonwoven fabric (6) is provided so as to cover the air passage cross section (d) of the filter housing (2) in addition to the pleated filter (4).

4. Switch cabinet arrangement according to claim 2 or 3, in which the nonwoven fabric (6) is coated and/or interspersed with the superabsorber (5) as granules, wherein the granules are held on the fibres by fibres of the nonwoven fabric (6) or by a binder.

5. Switch cabinet arrangement according to one of claims 2 to 4, in which the nonwoven fabric (6) has the superabsorber (5) only within a proportion of the air passage cross section (d) of the filter housing (2), wherein the proportion is preferably less than 50% of the air passage cross section (d).

6. Switch cabinet arrangement according to one of claims 2 to 5, in which the superabsorber (5) is arranged exclusively in a lower region of the nonwoven fabric (6) in the installed position of the air inlet or air outlet filter (1.1, 1.2) on a switch cabinet housing (100), while an upper region of the nonwoven fabric (6) in relation to the lower region is free of the superabsorber (5).

7. Switch cabinet arrangement according to one of claims 2 to 5, in which the superabsorber (5) is provided in or on the nonwoven fabric (6) in a crystalline state and has a volume as a hydrogel in a swollen state which is at least 40 times, preferably at least 70 times and particularly preferably at least 100 times greater than in the crystalline state.

8. Switch cabinet arrangement according to one of claims 2 to 6, in which the nonwoven fabric (6) has a sandwich structure, with a first and a second outer filter nonwoven fabric (7), between which an absorber layer (8) having the superabsorber (5) is arranged.

9. Switch cabinet arrangement according to claim 7, in which the absorber layer (8) is a further filter nonwoven fabric which is independent of the filter substrate (3) and which has the superabsorber (5).

10. Switch cabinet arrangement according to one of the preceding claims, in which the nonwoven fabric (6) is liquid-absorbent and/or hydrophobic, wherein the nonwoven fabric (6) preferably consists of thermally and/or mechanically bonded polyester fibers.

11. Switch cabinet arrangement according to claim 10, in which, at least in the case in which the nonwoven fabric (6) is hydrophobic, the nonwoven fabric (6) and/or the pleated filter (4) has a liquid-absorbent material strip, preferably a hydrophilic nonwoven fabric strip, on an underside.

12. Switch cabinet arrangement according to claim 11, in which the liquid-absorbent material strip is arranged outside the air passage cross section (d) of the filter housing (2).

13. Switch cabinet arrangement according to one of the preceding claims, in which the nonwoven fabric (6) has a basis weight of less than 250 g/m², preferably of less than 200 g/m² and particularly preferably of less than 180 g/m² .

14. Switch cabinet arrangement according to one of the preceding claims, in which the absorber mat of nonwoven fabric (6) is arranged downstream of the pleated filter (4) in the flow direction in the case of an air inlet filter (1.1) and upstream of the pleated filter (4) in the flow direction in the case of an air outlet filter, wherein the absorber mat of nonwoven fabric (6) is arranged adjacent to the pleated filter (4) or at a distance from the pleated filter (4).

15. Switch cabinet arrangement according to one of the preceding claims, in which the filter housing (2) has a filter housing cover (12) which has the lamellar grid (9) and can be pivoted with respect to a filter housing lower part (11) fixed in the housing wall (101) or can be removed therefrom, in which filter housing cover the pleated filter (4) is held, wherein an absorber mat of nonwoven fabric (6) is held in the filter housing lower part (11).

16. Switch cabinet arrangement according to one of the preceding claims, in which the filter housing (2) has a filter housing cover (12) which has the lamellar grid (9) and can be pivoted with respect to a filter housing lower part (11) or can be removed therefrom, in which filter housing cover the pleated filter (4) and an absorber mat of nonwoven fabric (6) are held.

## Revendications

1. Ensemble d'armoire électrique avec un boîtier d'armoire électrique (100) au moins un filtre d'entrée et de sortie d'air (1.1, 1.2) qui comprend un boîtier de filtre (2) qui est monté dans une paroi de boîtier verticale (101) du boîtier d'armoire électrique (100) et qui comprend, sur une face externe (102) du boîtier d'armoire électrique (100), une grille à lamelles (9), dans lequel, dans le boîtier de filtre (2), est disposé un substrat de filtre (3) avec un filtre à plis (4) qui recouvre entièrement une section transversale de passage d'air (d) du boîtier de filtre (2) et qui comprend un tapis absorbant les liquides en tissu non-tissé (6), **caractérisé en ce que** la grille à lamelles (9) comprend une pluralité de lamelles (10) s'étendant verticalement ou est constituée de lamelles (10) s'étendant parallèlement entre elles, dans lequel le filtre à plis (4) est disposé à 'intérieur du boîtier de filtre (2), orienté vers la grille à lamelles (9) et les lamelles s'étendent parallèlement aux plis du filtre à plis (4), de sorte que, entre des plis adjacents du filtre à plis (4), un canal (13) s'étendant verticalement et ouvert en direction de la grille à lamelles (9) est respectivement formé.

2. Ensemble d'armoire électrique selon la revendication 1, dans lequel le tissu non-tissé (6) comprend un super-absorbant (5), dans lequel le super-absorbant (5) est logé dans le tissu non-tissé (6) ou le tissu non-tissé (6) est revêtu avec le super-absorbant (5).

3. Ensemble d'armoire électrique selon la revendication 1 ou 2, dans lequel le filtre à plis (4) comprend le tissu non-tissé (6) ou le tissu non-tissé (6) est mis à disposition en plus du filtre à plis (4), de façon à recouvrir la section transversale de passage d'air (d) du boîtier de filtre (2).

4. Ensemble d'armoire électrique selon la revendication 2 ou 3, dans lequel le tissu non-tissé (6) est revêtu et/ou traversé par le super-absorbant (5) sous forme de granulé, dans lequel le granulé est maintenu par les fibres du tissu non-tissé (6) ou est maintenu sur les fibres par un liant.

5. Ensemble d'armoire électrique selon l'une des revendications 2 à 4, dans lequel le tissu non-tissé (6) comprend le super-absorbant (5) seulement dans une partie de la section transversale de passage d'air (d) du boîtier de filtre (2), dans lequel cette partie représente de préférence moins de 50 % de la section transversale de passage d'air (d).

6. Ensemble d'armoire électrique selon l'une des revendications 2 à 5, dans lequel le super-absorbant (5) est disposé exclusivement dans une zone inférieure du tissu non-tissé (6), vue dans la position d'installation du filtre d'entrée ou de sortie d'air (1.1, 1.2) sur un boîtier d'armoire électrique (100), tandis qu'une zone supérieure du tissu non-tissé (6), par rapport à la zone inférieure, est exempte du super-absorbant (5).

7. Ensemble d'armoire électrique selon l'une des revendications 2 à 5, dans lequel le super-absorbant (5) est mis à disposition dans un état cristallin dans ou sur le tissu non-tissé (6) et présente, dans un état gonflé, sous forme d'hydrogel, un volume qui est au moins 40 fois, de préférence au moins 70 fois et plus particulièrement de préférence au moins 100 fois plus grand que dans l'état cristallin.

8. Ensemble d'armoire électrique selon l'une des revendications 2 à 6, dans lequel le tissu non-tissé (6) présente une structure en sandwich, avec un premier et un deuxième non-tissé de filtre externe (7), entre lesquels est disposée une couche absorbante (8) contenant le super-absorbant (5).

9. Ensemble d'armoire électrique selon la revendication 7, dans lequel la couche absorbante (8) est un autre non-tissé de filtre indépendant du substrat de filtre (3), qui comprend le super-absorbant (5).

10. Ensemble d'armoire électrique selon l'une des revendications précédentes, dans lequel le tissu non-tissé (6) absorbe les liquides et/ou est hydrophobe,
dans lequel le tissu non-tissé (6) est constitué de préférence de fibres de polyester liées thermiquement et/ou mécaniquement.

11. Ensemble d'armoire électrique selon la revendication 10, dans lequel, au moins dans le cas où le tissu non-tissé (6) est hydrophobe, le tissu non-tissé (6) et/ou le filtre à plis (4) présente, sur une face inférieure, une bande de matériau absorbant les liquides, de préférence une bande de non-tissé hydrophile.

12. Ensemble d'armoire électrique selon la revendication 11, dans lequel la bande de matériau absorbant les liquides est disposée à l'extérieur de la section transversale de passage d'air (d) du boîtier de filtre (2).

13. Ensemble d'armoire électrique selon l'une des revendications précédentes, dans lequel le tissu non-tissé (6) présente un poids surfacique inférieur à 250 g/m², de préférence inférieur à 200 g/m² et plus particulièrement de préférence inférieur à 180 g/m².

14. Ensemble d'armoire électrique selon l'une des revendications précédentes, dans lequel le tapis absorbant en tissu non-tissé (6) est disposé, pour un filtre d'entrée d'air (1.1), en aval du filtre à plis (4), dans la direction d'écoulement et, pour un filtre de sortie d'air, en amont du filtre à plis (4), dans la direction d'écoulement, dans lequel le tapis absorbant en tissu non-tissé (6) est disposé à proximité du filtre à plis (4) ou à une certaine distance du filtre à plis (4).

15. Ensemble d'armoire électrique selon l'une des revendications précédentes, dans lequel le boîtier de filtre (2) comprend un couvercle de boîtier de filtre (12) comprenant la grille à lamelles (9) et pivotant par rapport à une partie inférieure de boîtier de filtre (11) fixée dans la paroi de boîtier (101) ou pouvant être retiré de celle-ci, dans lequel le filtre à plis (4) est maintenu, dans lequel un tapis absorbant en tissu non-tissé (6) est maintenu dans la partie inférieure du boîtier de filtre (11).

16. Ensemble d'armoire électrique selon l'une des revendications précédentes, dans lequel le boîtier de filtre (2) comprend un couvercle de boîtier de filtre (12) comprenant la grille à lamelles (9) et pivotant par rapport à une partie inférieure de boîtier de filtre (11) ou pouvant être retiré de celle-ci, dans lequel le filtre à plis (4) et un tapis absorbant en tissu non-tissé (6) sont maintenus.
